# DEMANDE DE BREVET EUROPEEN

(11) **EP 3 699 952 A1**
(43) Date de publication de la demande: **26.08.2020**
(21) Numéro de dépôt: 20158671.6
(22) Date de dépôt: 21.02.2020
(51) Int. Cl.: H01L 21/20, H01L 23/498, H01L 23/14, H01L 21/683, H01L 23/00

(54) **PROCÉDÉ DE TRANSFERT D'UN FILM MINCE DEPUIS UN SUBSTRAT SUR UN SUPPORT SOUPLE**

(30) Priorité: 21.02.2019 FR 1901735
(71) Demandeur: Commissariat à l'Energie Atomique et aux Energies Alternatives, 75015 Paris (FR)
(72) Inventeur: MICHAUD, Laurent, 38054 GRENOBLE Cedex 9 (FR); CASTAN, Clément, 38054 GRENOBLE Cedex 9 (FR); FOURNEL, Frank, 38054 GRENOBLE Cedex 9 (FR); MONTMEAT, Pierre, 38054 GRENOBLE Cedex 9 (FR)
(74) Mandataire: Decobert, Jean-Pascal

(57) **Abrégé**

L'invention concerne les procédés de transfert d'un film mince 11 depuis un substrat 12 sur un support souple 2. Le procédé comprend :
- Reporter le support souple par une couche de polymère 21, réticulable sous ultraviolets, directement sur le film mince, l'énergie d'adhérence du polymère évoluant en fonction de son taux de réticulation, en décroissant jusqu'à un point d'énergie d'adhérence minimale atteint pour un taux de réticulation nominal, puis en croissant pour un taux de réticulation supérieur au taux de réticulation nominal, puis
- Appliquer, sur la couche de polymère, une insolation aux ultra-violets paramétrée de sorte à rigidifier la couche de polymère et avoir une énergie d'adhérence entre le film mince et le support souple supérieure à une énergie d'adhérence entre le film mince et le substrat, puis
- Retirer le substrat.

L'invention trouve des applications dans le domaine de l'électronique sur support souple.

## Description

### DOMAINE TECHNIQUE

L'invention concerne les procédés de transfert d'un film mince sur un support souple. Elle trouve des applications particulièrement avantageuses dans le domaine de l'électronique sur support souple.

### ÉTAT DE LA TECHNIQUE

Depuis une vingtaine d'années, l'électronique sur support souple connait un essor remarquable. Les applications sont variées : cellules photovoltaïques, diodes organiques, capteurs biologiques pour les mesures in vivo, etc.

Dans ce contexte, il apparait souvent nécessaire d'élaborer un matériau, bien souvent inorganique, à base duquel le circuit électronique est constitué, qui puisse être associé à un matériau flexible, comme un polymère organique, à base duquel le support souple est constitué. Il faut assurer en effet une bonne cohésion entre le matériau inorganique constitutif du circuit électronique, qui se présente sous la forme d'un film plus ou moins épais, et le support souple.

Dans le cas où le film est à base d'un matériau semi-conducteur cristallisé, les méthodes de transfert de film sont largement utilisées. Par exemple, P. Montméat et al. (ECS Trans. 75, 247 (2016)) ont pu mettre au point le transfert d'un film de silicium de 200 nm, depuis un substrat SOI (pour Silicium-On-Insulator), sur un support temporaire peu adhésif.

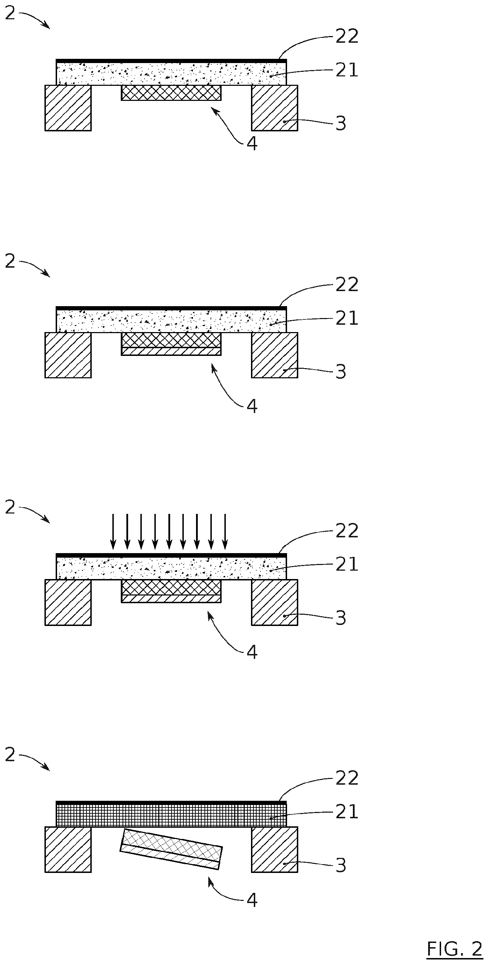

Il existe par ailleurs des procédés de fabrication de composants électroniques qui mettent en œuvre des films adhésifs souples (ou « tape » selon la terminologie anglo-saxonne). Ces films adhésifs souples sont dits de type « UV-release » ou « thermal-release », selon qu'ils permettent de libérer les composants électroniques qu'ils supportent à la suite d'une insolation aux ultra-violets ou à la suite d'un traitement thermique. Généralement, les films adhésifs souples 2 de type « UV-release » sont utilisés, de la façon illustrée sur la figure 2 annexée, soit pour faciliter la manipulation des plaques (ou « wafer » selon la terminologie anglo-saxonne) ou des puces fragiles 4, soit pour protéger des plaques ou des puces 4 lors de procédés agressifs ou contaminants, tels que le meulage et la découpe. L'adhérence des composants électroniques 4 au film adhésif souple 2 est souvent garantie par la présence, dans le film adhésif, d'une couche adhésive 21 en polymère réticulable, tel qu'un polyacrylate réticulable aux UV. L'énergie d'adhérence des composants électroniques 4 au film adhésif souple 2 est modulable en fonction du taux de réticulation du polymère : elle peut être très forte lorsqu'il s'agit d'assurer le maintien ou la protection des plaques 4, et elle peut être suffisamment faible pour faciliter la libération des plaques 4 en fin de fabrication. Un traitement thermique ou une insolation par UV diminue fortement l'énergie d'adhérence du film souple 2. En particulier, l'homme du métier sait qu'une insolation UV selon les préconisations du fabricant (ex : 1 J/cm² pour le film Furukawa SP-537T-230) va polymériser l'adhésif du film souple « UV-release » et dégrader ses propriétés d'adhérence.

Il existe un besoin pour un procédé de transfert d'un film mince sur un support souple qui soit particulièrement adapté à la fabrication de dispositifs microélectroniques trouvant notamment des applications avantageuses dans le domaine de l'électronique sur support souple.

Un objet de la présente invention est donc de proposer un procédé de transfert d'un film mince depuis un substrat sur un support souple qui soit particulièrement adapté à la fabrication de dispositifs microélectroniques trouvant de préférence des applications avantageuses dans le domaine de l'électronique sur support souple.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ

Pour atteindre cet objectif, selon un mode de réalisation, on prévoit un procédé de transfert d'un film mince depuis un substrat sur un support souple, le procédé comprenant les étapes suivantes:
- Fournir un empilement comprenant au moins un film mince s'étendant sur une première face du substrat, chaque film mince adhérant à la première face du substrat avec une énergie d'adhérence donnée,
- Fournir un support souple comprenant au moins une couche à base d'un polymère réticulable par insolation aux ultra-violets, le polymère réticulable étant tel qu'au moins sa rigidité et son énergie d'adhérence évoluent en fonction de son taux de réticulation, l'énergie d'adhérence du polymère réticulable évoluant de façon non monotone en fonction du taux de réticulation du polymère, en décroissant depuis une énergie d'adhérence initiale, correspondant à un taux de réticulation initial du polymère, jusqu'à atteindre une énergie d'adhérence minimale pour un taux de réticulation nominal, puis en croissant pour un taux de réticulation supérieur au taux de réticulation nominal,
- Reporter la couche de polymère du support souple directement sur le film mince de l'empilement, le polymère présentant un taux de réticulation inférieur au taux de réticulation nominal, puis
- Appliquer, sur la couche de polymère du support souple, une insolation aux ultra-violets paramétrée de sorte que le taux de réticulation du polymère soit supérieur au taux de réticulation nominal pour rigidifier la couche de polymère et avoir une énergie d'adhérence entre le film mince et le support souple supérieure à l'énergie d'adhérence entre le film mince et le substrat, puis
- Retirer le substrat,
   de sorte que le film mince se trouve transféré sur le support souple.

Ainsi, l'insolation est paramétrée de sorte à dépasser une dose d'insolation nominale qui amènerait le polymère au taux de réticulation nominal correspondant au point d'énergie d'adhérence minimale. Le procédé exploite l'incurvation de l'évolution de l'énergie d'adhérence du polymère en fonction de son taux de réticulation, ce dernier dépendant de l'insolation aux ultraviolets qui lui est appliquée. Il prévoit avantageusement de regagner en énergie d'adhérence entre le support souple et le film mince par rapport à l'énergie d'adhérence minimale, tout en rigidifiant le support souple.

Un autre aspect de modes de réalisation concerne un procédé de transfert d'un film mince depuis un substrat sur un support souple, le procédé comprenant les étapes suivantes:
- Fournir un empilement comprenant au moins un film mince s'étendant sur une première face du substrat, chaque film mince adhérant à la première face du substrat avec une énergie d'adhérence donnée,
- Fournir un support souple comprenant au moins une couche à base d'un polymère réticulable par insolation aux ultra-violets, ce polymère pouvant être un acrylate,
- Reporter la couche de polymère du support souple directement sur le film mince de l'empilement, le polymère présentant un taux de réticulation inférieur à un taux de réticulation nominal correspondant à une énergie d'adhérence minimale, puis
- Appliquer, sur la couche de polymère du support souple, une insolation aux ultra-violets paramétrée de sorte que le taux de réticulation du polymère soit supérieur au taux de réticulation nominal et soit configuré pour avoir une énergie d'adhérence entre le film mince et le support souple supérieure à l'énergie d'adhérence entre le film mince et le substrat, puis
- Retirer le substrat,
   de sorte que le film mince se trouve transféré sur le support souple.

Un autre aspect concerne un procédé de fabrication d'un dispositif microélectronique comprenant la mise en œuvre d'un procédé de transfert tel qu'introduit ci-dessus.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 représente schématiquement les étapes d'un procédé de transfert testé par les inventeurs dans le cadre des réflexions ayant conduit à la présente invention ;
La figure 2 représente schématiquement la façon dont sont utilisés ordinaire les films adhésifs souples tels que décrits en introduction de la présente ;
La figure 3 représente graphiquement d'une part l'évolution du module d'Young, d'autre part l'évolution de l'énergie d'adhérence, du film adhésif souple Furukawa SP-537T-230 en fonction de la dose d'insolation aux ultraviolets qui lui est appliquée ;
La figure 4 représente schématiquement les étapes du procédé de transfert selon un mode de réalisation de l'invention ; et
La figure 5 représente un ordinogramme des étapes du procédé de transfert selon un mode de réalisation de l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches et films ne sont pas représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
- la rigidité du polymère réticulable croissant de façon monotone à mesure que le taux de réticulation du polymère croît, l'application de l'insolation aux ultra-violets peut être paramétrée de sorte que le support souple présente, après l'application de l'insolation aux ultra-violets et avant le retrait du substrat, un module d'Young au moins 1,5 fois, de préférence au moins 2 fois, plus élevé que son module d'Young avant l'application de l'insolation aux ultra-violets. La rigidité de la couche de polymère du support souple peut ainsi être suffisamment augmentée, du fait de l'insolation aux ultraviolets, pour éviter la fissuration du film fin lors du retrait du substrat.
- En alternative ou en complément à la caractéristique précédente, l'application de l'insolation aux ultra-violets est paramétrée de sorte que le support souple présente, après l'application de l'insolation aux ultra-violets et avant le retrait du substrat, un module d'Young inférieur à 100 fois, de préférence inférieur à 40 fois, son module d'Young avant l'application de l'insolation aux ultra-violets. L'on s'assure ainsi que la couche de polymère du support souple reste suffisamment souple pour des applications dans le domaine de l'électronique sur support souple ;
- Selon une autre caractéristique, le taux de réticulation nominal étant connu pour être atteint en appliquant une dose d'insolation nominale donnée sur la couche en polymère telle que reportée, l'application de l'insolation aux ultra-violets est paramétrée de sorte d'appliquer, sur la couche en polymère telle que reportée, une dose d'insolation au moins 3 fois plus élevée que ladite dose d'insolation nominale ; la dose d'insolation est fonction du matériau à insoler ; en effet, le comportement (en adhérence et en rigidité) peut varier d'un polymère réticulable à un autre ; en particulier, la remontée de l'adhérence, après la taux nominal, peut être plus ou moins rapide ; cela peut se produire bien au-delà d'une dose d'insolation 3 fois plus élevée que la dose nominale ;
- Selon une autre caractéristique, le taux de réticulation nominal étant connu pour être atteint en appliquant une dose d'insolation nominale donnée sur la couche en polymère telle que reportée, l'application de l'insolation aux ultra-violets est paramétrée de sorte d'appliquer, sur la couche en polymère telle que reportée, une dose d'insolation inférieure à 10 fois, de préférence inférieure à 4 fois, ladite dose d'insolation nominale.
- L'énergie d'adhérence minimale entre le film mince et le support souple peut être inférieure à l'énergie d'adhérence entre le film mince et le substrat. Dans ce cas, le procédé permet donc de regagner suffisamment en énergie d'adhérence du film mince sur le support souple pour que cette dernière devienne supérieure à l'énergie d'adhérence entre le film mince et le substrat, de sorte que le substrat puisse être retiré ;
- La fourniture du support souple peut être paramétrée de sorte que le polymère réticulable présente une énergie d'adhérence avec le film mince supérieure à l'énergie d'adhérence entre le film mince et le substrat, le report de la couche de polymère sur le film mince comprenant alors un collage de l'un sur l'autre ;
- Le support souple peut présenter, avant l'application de l'insolation aux ultra-violets, un module d'Young strictement inférieur à 10 MPa, de préférence inférieur à 2 MPa. Dès lors que le support souple présente initialement une souplesse suffisante, le report du support souple sur l'empilement permet d'atteindre, avant même l'application de l'insolation, un bon contact, voire un bon collage, entre le support souple et le film mince ;
- Le polymère réticulable peut comprendre, ou être constitué de, un polymère acrylate ;
- Le film mince a de préférence une épaisseur strictement inférieure à 1 µm, de préférence inférieure à 200 nm ;
- Le film mince peut être composé à base de, ou être constitué de, un matériau magnétique, piézo-électrique, métallique ou semi-conducteur (tel que le silicium, le germanium, le nitrure d'aluminium, le nitrure de gallium et le phosphure d'indium) ;
- Le film mince peut comprendre, ou être constitué de, un matériau cristallin. Du fait de la réticulation du polymère, le support souple peut être suffisamment rigidifié pour que le retrait du substrat n'induise pas de fissuration(s) du film mince, y compris lorsque celui-ci est composé à base d'un matériau cristallin ;
- Le report de la couche de polymère sur le film mince peut être réalisé par laminage ou par épandage d'au moins une partie du support souple, et plus particulièrement d'au moins la couche de polymère, sur le film mince ;
- Le substrat est de préférence rigide, et peut plus particulièrement présenter un module d'Young au moins 10 fois supérieur au module d'Young du support souple après l'application de l'insolation aux ultra-violets, le module d'Young du substrat étant par exemple supérieur à 10 GPa ;
- Le support souple peut comprendre en outre un film structurant sur lequel la couche en polymère est déposée, le film structurant étant en un matériau transparent aux ultra-violets, par exemple en polyoléfine. En complément ou en alternative, le support souple peut être fourni fixé sur un cadre rigide configuré pour faciliter la manipulation du support souple ;
- L'empilement fourni peut comprendre une pluralité de films minces disjoints entre eux et répartis sur la première face du substrat, de sorte que la pluralité de films minces se trouve transférée sur le support souple.

On entend par « inférieur » et « supérieur », « inférieur ou égal » et supérieur ou égal », respectivement. L'égalité est exclue par l'usage des termes « strictement inférieur » et « strictement supérieur ». Egalement, les expressions du type « égal, inférieur, supérieur » s'entendent de comparaisons pouvant accommoder certaines tolérances, notamment selon l'échelle de grandeur des valeurs comparées et les incertitudes de mesure. Des valeurs sensiblement égales, inférieures ou supérieures entrent dans le cadre d'interprétation de l'invention.

On entend par un paramètre « sensiblement égal/supérieur/inférieur à » une valeur donnée que ce paramètre est égal/supérieur/inférieur à la valeur donnée, à plus ou moins 20 %, voire 10 %, près de cette valeur. On entend par un paramètre « sensiblement compris entre » deux valeurs données que ce paramètre est au minimum égal à la plus petite valeur donnée, à plus ou moins 20 %, voire 10 %, près de cette valeur, et au maximum égal à la plus grande valeur donnée, à plus ou moins 20 %, voire 10 %, près de cette valeur.

On entend par un film à base d'un matériau A, un film comprenant ce matériau A et éventuellement d'autres matériaux.

Dans la description qui suit, les épaisseurs sont généralement mesurées selon des directions perpendiculaires au plan de la face inférieure d'une couche ou d'un substrat sur lequel la couche est disposée. Ainsi, les épaisseurs sont généralement prises selon une direction verticale sur les figures représentées.

Les paramètres d'une réticulation par UV sont généralement la puissance, le temps d'exposition et surtout le procédé d'exposition.

Les inventeurs désignés par la présente, forts de la connaissance des arts antérieurs présentés en introduction, ont été amenés à considérer que les films adhésifs souples, utilisés pour la manipulation ou pour la protection de plaques ou de puces, devraient *a priori* être des supports bien adaptés pour procéder à des transferts de films minces.

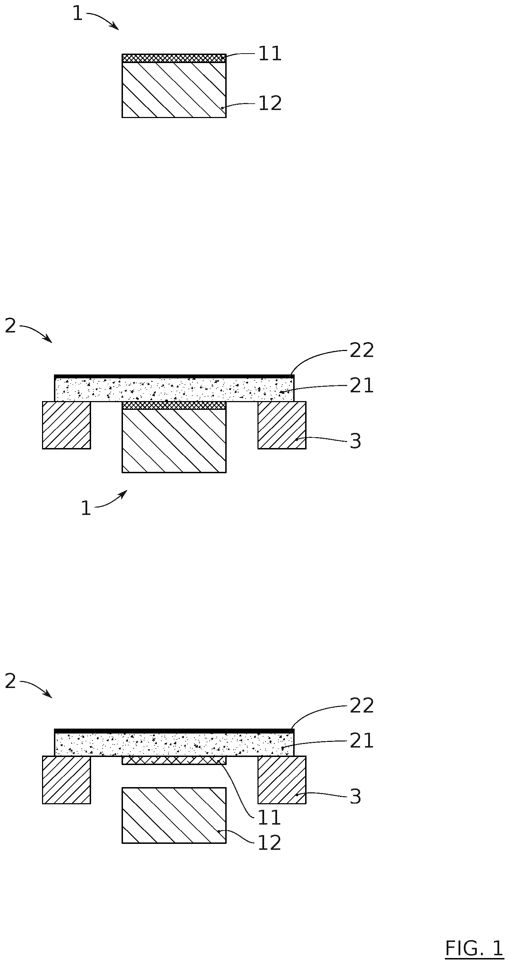

Afin de vérifier la pertinence de cette idée originale, ils ont considéré la structure initiale, présentée en figure 1. Ils ont plus particulièrement fourni un empilement 1 comprenant un film mince 11 s'étendant sur une première face d'un substrat 12, le film mince adhérant à la première face du substrat avec une énergie d'adhérence donnée. Plus particulièrement encore, la structure initiale considérée comprend un empilement 1 dont le film fin 11, solidaire du substrat rigide 12, présente une épaisseur strictement inférieure à 1 µm, de préférence inférieure à 200 nm. Ils ont fourni par ailleurs un support souple 2 de type « UV-release », comprenant au moins une couche 21 à base d'un polymère réticulable par insolation aux ultra-violets. De façon à transférer le film fin 11 sur le support flexible 2, l'idée est de venir coller le support flexible 2 sur la surface du film fin 11 et de transférer ainsi ce film 11 sur le support souple 2, un tel transfert requérant que l'énergie d'adhérence entre le film fin 11 et le support souple 2 soit supérieure à l'énergie d'adhérence entre le film fin 11 et le substrat rigide 12. Cette condition est remplie lorsque l'on utilise par exemple le film Furukawa SP-537T-230, en tant que support souple 2, afin d'y transférer un film fin 11 depuis la structure initiale. Notons ici que le polymère réticulable d'un tel film est constitué d'un polymère acrylate. En référence aux figures 1, 2 et 4, notons également que :
- le film Furukawa SP-537T-230 comprend en outre un film structurant 22 sur lequel la couche en polymère 21 est déposée, le film structurant 22 étant en un matériau transparent aux ultra-violets, par exemple en polyoléfine, et que
- le film Furukawa SP-537T-230 est fourni fixé sur un cadre rigide 3 configuré pour en faciliter la manipulation.

Dans ces conditions pourtant *a priori* propices, les inventeurs ont observés qu'un tel procédé de transfert aboutit malencontreusement à la fissuration du film fin 11 sur le support souple 2. Une telle fissuration du film fin 11 est d'autant plus problématique que le film présente avant son transfert des caractéristiques cristallines que l'on cherche à conserver. Le procédé de transfert initialement testé, et tel qu'illustré sur la figure 1, ne permet donc pas un transfert dans de bonnes conditions.

De façon à éviter la fissuration du film mince 11, les inventeurs ont pensé à modifier les propriétés mécaniques du support souple 2 avant le transfert. En effet, ils ont pressenti que la fissuration du film mince 11, du fait de son transfert depuis le substrat 12 sur le support souple 2, est liée à un transfert de contraintes élastiques qui pourrait être évité, ou du moins limité, en rigidifiant le support souple 2 ; or il est connu de rigidifier le support souple 2 en le polymérisant par insolation aux ultraviolets, le polymère réticulable étant tel qu'au moins sa rigidité évolue en fonction de son taux de réticulation. Toutefois, le support souple 2 considéré, notamment dans l'exemple susmentionné, est justement configuré pour que, soumis à une dose d'insolation préconisée par son fabricant et que l'homme du métier est donc incité à respecter, son énergie d'adhérence diminue, jusqu'à être minimale, afin de permettre la libération de la plaque ou de la puce qu'il est conçu pour supporter. De fait, les inventeurs ont observé que l'énergie d'adhérence du support souple 2 qui est atteinte en l'insolant avec la dose d'insolation préconisée est inférieure à l'énergie d'adhérence entre le film mince 11 et le substrat 12 considérés ; il n'est dès lors plus possible de transférer le film mince 11 depuis le substrat 12 sur le support souple 2.

Le procédé selon l'invention vise à permettre tout de même le transfert du film mince 11 depuis le substrat 12 sur le support souple 2, notamment dans la configuration testée par les inventeurs de la façon détaillée ci-dessus.

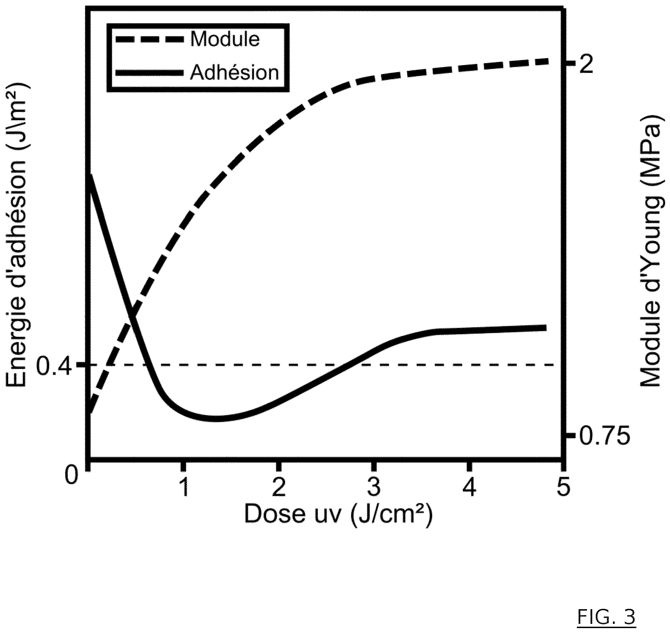

Forts de leurs observations, les inventeurs ont cherché à aller plus avant dans la caractérisation du support souple en fonction de l'insolation aux ultra-violets qui lui est appliquée. Etant connu que les paramètres d'une réticulation par UV sont généralement la puissance, le temps d'exposition et surtout le procédé d'exposition, ladite caractérisation les a conduit à établir le graphique de la figure 3 annexée. Selon ce graphique, il apparaît que :
- d'une part, l'énergie d'adhérence du polymère réticulable évolue de façon non monotone en fonction du taux de réticulation du polymère, en décroissant depuis une énergie d'adhérence initiale, correspondant à un taux de réticulation initial du polymère, jusqu'à atteindre une énergie d'adhérence minimale pour un taux de réticulation nominal (celui préconisé par le fabricant), puis en croissant pour un taux de réticulation supérieur au taux de réticulation nominal, et
- d'autre part, la rigidité du polymère réticulable, et donc du support souple 2, croît de façon monotone à mesure que le taux de réticulation du polymère croît,
   le taux de réticulation du polymère étant directement lié à la dose d'insolation aux ultra-violets appliqué sur la couche de polymère.

La figure 3 présente une courbe d'évolution de l'adhérence dans un exemple expérimental donné. Il peut s'agir d'un acrylate dont le comportement suit bien cette évolution. Cette figure 3, et en particulier sa courbe d'adhérence, pourra connaitre des variations de forme selon le matériau employé. Par exemple, lorsque le taux nominal d'insolation est atteint, l'adhérence peut rester stable, à un niveau de seuil bas, durant une large gamme de taux d'insolation. On peut alors rencontrer un pallier bas. Cependant, à partir d'un certain taux d'insolation, l'adhérence finit par remonter. Ce dernier comportement, révélé par les inventeurs, n'est pas rencontré dans l'état de la technique, notamment parce que le taux d'insolation n'est jamais poussé aussi loin.

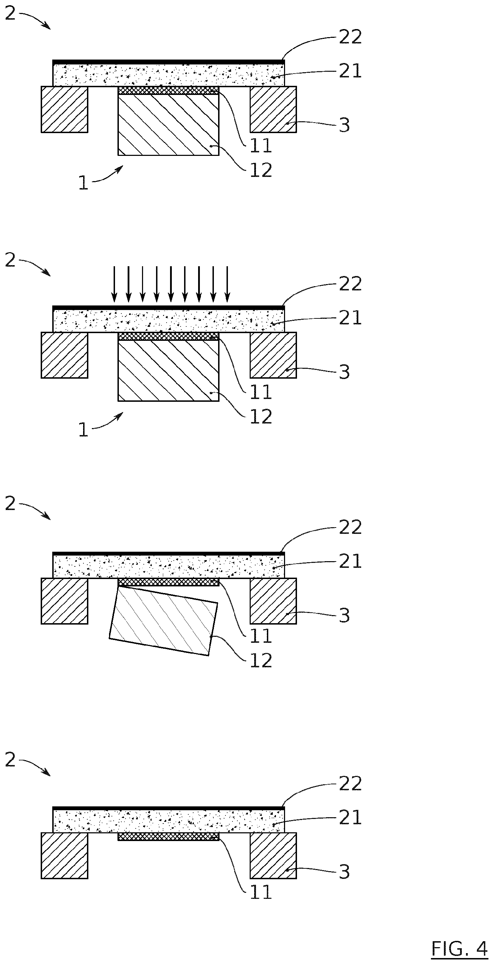

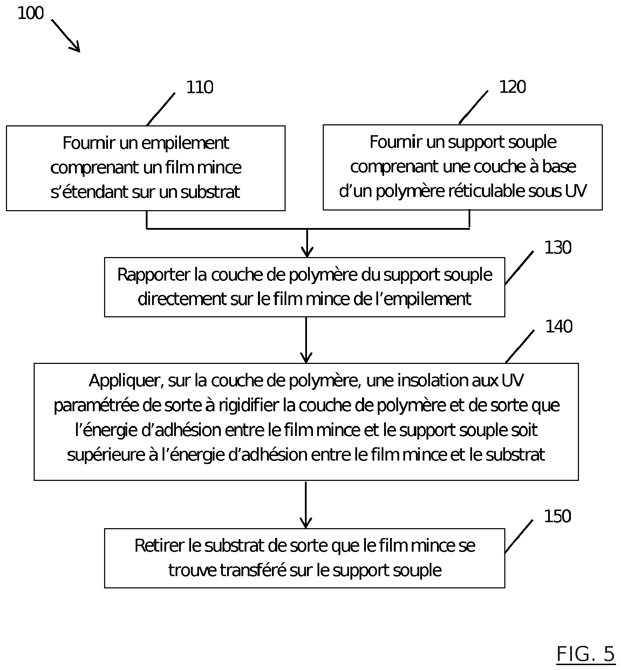

C'est au vu de cette caractérisation que les inventeurs ont imaginé le procédé selon l'invention qui est décrit ci-dessous en référence aux figures 4 et 5.

Le procédé de transfert 100 selon l'invention comprend, tout comme dans le test détaillé plus haut, les étapes suivantes :
- Fournir 110 un empilement 1 comprenant au moins un film mince 11 s'étendant sur une première face du substrat 12, chaque film mince 11 adhérant à la première face du substrat 10 avec une énergie d'adhérence donnée, et
- Fournir 120 un support souple 2 comprenant au moins une couche 21 à base d'un polymère réticulable par insolation aux ultra-violets, puis
- Reporter 130 la couche de polymère 21 du support souple 2 directement sur ledit au moins un film mince 11 de l'empilement 1, le polymère présentant un taux de réticulation inférieur au taux de réticulation nominal, puis
- Appliquer 140, sur la couche de polymère 21 du support souple 2, une insolation aux ultra-violets, puis
- Retirer 150 le substrat.

Le procédé de transfert 100 selon l'invention se distingue du test détaillé plus haut essentiellement en ce que l'application 140 est paramétrée de sorte que le taux de réticulation du polymère soit supérieur au taux de réticulation nominal. Une surdose d'insolation relativement à la dose d'insolation nominale est donc appliquée 140 sur la couche de polymère 21 du support souple 2 qui a pour conséquence, comme le graphique de la figure 3 le quantifie :
- de rigidifier la couche de polymère 21, au-delà de la rigidification atteinte avec application de la dose d'insolation nominale, ce qui permet de mieux limiter encore le phénomène de fissuration à éviter, et
- de regagner en énergie d'adhérence entre chaque film mince 11 et le support souple 2 de sorte qu'elle soit supérieure à l'énergie d'adhérence entre le film mince 11 et le substrat 12, ce qui permet de retirer le substrat 12,
   pour ainsi obtenir le transfert 100 du film mince 11 sur le support souple 2 dans de bonnes conditions, préservant l'intégrité, et notamment la nature cristalline, de chaque film mince.

Le procédé selon l'invention propose donc une utilisation des films souples adhésifs qui diffère de celle présentée dans l'état de l'art. L'homme du métier insole habituellement les films souples adhésifs pour diminuer leur adhérence à un empilement et faciliter le décollement total de l'empilement. Selon son mode d'utilisation usuelle, l'aspect mécanique des films souples adhésifs ne doit pas trop changer pour permettre en général des étapes de 'pick and place'. En première approche, une insolation d'un film souple adhésif ne serait pas utilisée pour transférer dans de bonnes conditions un film fin sur ce film utilisé en tant que support souple. Selon le procédé de l'invention, une insolation plus poussée, relativement à celle que requière l'utilisation usuelle qui en est fait, permet d'améliorer l'adhérence du film souple et d'augmenter fortement la rigidité afin d'assurer un comportement mécanique idéal du film souple adhésif, en tant que support souple, pour le transfert de film(s) fin(s).

De préférence, le support souple 2 présente, après l'application 140 de l'insolation aux ultra-violets et avant le retrait 150 du substrat 12, un module d'Young au moins 1,5 fois, de préférence au moins 2 fois, plus élevé que son module d'Young avant l'application 140 de l'insolation aux ultra-violets.

L'on s'assure ainsi que la rigidité de la couche de polymère du support souple 2 soit suffisamment augmentée, du fait de l'insolation aux ultraviolets, pour éviter, ou du moins limiter, la fissuration du film fin lors du retrait du substrat.

Encore plus préférentiellement, l'application 140 de l'insolation aux ultra-violets est paramétrée de sorte que le support souple 2 présente, après l'application 140 de l'insolation aux ultra-violets et avant le retrait 150 du substrat 12, un module d'Young inférieur à 100 fois, de préférence inférieur à 40 fois, son module d'Young avant l'application 140 de l'insolation aux ultra-violets.

L'on s'assure ainsi que la couche de polymère 21 du support souple 2 reste suffisamment souple pour qu'un dispositif microélectronique comprenant le support souple 2, car étant fabriqué en mettant en œuvre le procédé selon l'invention, et éventuellement d'autres étapes de fabrication, soit adapté à des applications dans le domaine de l'électronique sur support souple.

Par ailleurs, le support souple 2 présente de préférence, avant l'application 140 de l'insolation aux ultra-violets, un module d'Young strictement inférieur à 10 MPa, de préférence inférieur à 2 MPa. Dès lors, le module d'Young du support souple 2 est, après l'application 140 de l'insolation aux ultraviolets et avant le retrait 150 du substrat 12, inférieur à 100 MPa, de préférence inférieur à 8 MPa. En comparaison, le substrat 12 est rigide; il présente typiquement un module d'Young au moins 10 fois supérieur au module d'Young du support souple 2 après l'application 140 de l'insolation aux ultra-violets. Le module d'Young du substrat est par exemple supérieur à 1GPa.

De façon correspondante, les limitations préférentielles susmentionnées peuvent être exprimées en termes du taux de réticulation de la couche de polymère 21. Ainsi, le taux de réticulation nominal étant connu pour être atteint en appliquant une dose d'insolation nominale donnée sur la couche en polymère telle que reportée 130, l'application 140 de l'insolation aux ultra-violets est de préférence paramétrée de sorte d'appliquer, sur la couche en polymère telle que reportée 130, une dose d'insolation au moins 3 fois plus élevée que ladite dose d'insolation nominale. De même, l'application 140 de l'insolation aux ultra-violets est encore plus préférentiellement paramétrée de sorte d'appliquer, sur la couche en polymère telle que reportée 130, une dose d'insolation inférieure à 10 fois, de préférence inférieure à 4 fois, ladite dose d'insolation nominale. On notera que les coûts liés à la mise en œuvre de l'étape d'application 140 de l'insolation aux ultra-violets sont ainsi bornés.

Le report 130 de la couche de polymère 21 sur le film mince 11 peut être réalisé par laminage ou par épandage d'au moins une partie du support souple 2, et plus particulièrement d'au moins la couche de polymère 21, sur le film mince 11. Dès lors, la fourniture 120 du support souple 2 peut ne pas être paramétrée de sorte que le polymère réticulable présente une énergie d'adhérence avec le film mince 11 supérieure à l'énergie d'adhérence entre le film mince 11 et le substrat 12. Le polymère réticulable peut même être initialement dans un état de fluidité ne lui garantissant aucune propriété adhésive, si bien que le report 130 de la couche de polymère 21 sur le film mince 11 ne comprend pas un collage de l'un sur l'autre. Lorsque le polymère est initialement dans un état de réticulation lui garantissant une propriété adhésive, éventuellement supérieure à l'énergie d'adhérence entre le film mince 11 et le substrat 12, il est préférable que son module d'Young soit tout de même inférieur à strictement inférieur à 10 MPa, de préférence inférieur à 2 MPa, comme déjà spécifié ci-dessus, afin d'assurer un bon collage du support souple 2 sur le film mince 11. Lorsque le support souple 2 est laminé sur le film mince, il est préférable qu'il soit maintenu dans un cadre rigide 3 qui en facilite la manipulation. L'utilisation d'un tel cadre 3 n'est cependant pas obligatoire, notamment lorsque le polymère réticulable est épandu sur le film mince 11. Dans ce dernier cas également, l'utilisation d'un film structurant 22 peut être avantageuse et consister à laminer le film structurant 22 sur le polymère épandu. Toutefois, l'utilisation d'un film structurant n'est pas nécessaire, la couche de polymère pouvant être initialement suffisamment rigide.

Le retrait 150 du substrat 12 depuis le film mince 11 peut être réalisé mécaniquement. Par exemple, le substrat 12 peut être meulé depuis sa seconde face opposée à sa première face. En alternative, il n'est pas exclu d'exercer une contrainte mécanique de détachement pour séparer ou amorcer le décollement du substrat 12 depuis le film mince 11. En alternative ou en complément, le retrait 150 du substrat 12 depuis le film mince 11 peut être réalisé chimiquement, pour peu que le film souple soit suffisamment résistant à la chimie mise en jeu.

A titre nullement limitatif, et strictement illustratif, deux exemples de réalisation spécifiques sont donnés ci-dessous qui retrace le cheminement suivi par les inventeurs pour parvenir au procédé selon l'invention. Ces exemples de réalisation ont été implémentés sur des plaques (ou « wafer » selon la terminologie anglo-saxonne) de 200 mm de diamètre.

### Exemple 1 :

Selon ce premier exemple, un composé fluoré (3M EGC novec 2702) est déposé par enduction centrifuge sur une structure de type SOI comprenant, depuis sa première face, une couche de 200 nm de Si, puis une couche de 400 nm d'oxyde enterré. A l'aide de l'adhésif BrewerBOND 305, cette structure est collée sur la première face d'une poignée temporaire, utilisée par la suite en tant que substrat 12, et constituée d'une plaquette de silicium. L'énergie d'adhérence entre la poignée temporaire et la structure est évaluée à 0,4 J/m² (méthode DCB selon W.P. Maszara, G. Goetz, A. Caviglia, and J.B. McKitterick, J. Appl. Phys. 64, 4943 (1988)).

Le silicium massif et la couche d'oxyde enterré sont ensuite retirés de la structure par une série d'amincissements mécanique et chimique.

Sur le film mince ainsi obtenu, on vient laminer un film adhésif flexible Furukawa SP-537T-230, en tant que support souple 2, à l'aide d'un cadre rigide maintenant le film adhésif flexible. On retire ensuite mécaniquement la poignée temporaire. Le film de silicium monocristallin de 200 nm se trouve alors sur le film flexible. On observe de nombreuses fissures sur le film fin. En outre, on observe que la totalité du film fin est transféré sur le film souple. Ce qui indique que, sans aucune insolation, l'énergie d'adhérence entre le film souple (non insolé) et le film fin est supérieure à 0,4 J/m².

Une alternative au procédé précédent consiste à exposer le film souple à différentes doses UV, puis à démonter le film mince.

Lorsque la dose d'insolation est proche de celle préconisée par le fabricant, soit une dose sensiblement égale à 1 J/cm², on observe que le film mince n'est transféré que partiellement. Dans ce cas, l'énergie d'adhérence entre le film souple et le film fin est donc plus faible que 0,4 J/m².

Lorsque la dose d'insolation est proche de 4 J/cm², on observe un transfert complet du film fin sur le film souple. Cela démontre que l'adhérence du film souple obtenue après une insolation de 4 J/cm² est meilleure que l'adhérence obtenue après une insolation de 1 J/cm² et en particulier bien supérieure à 0,4 J/m². En outre, le module d'Young du film souple est sensiblement égal à 1,75 MPa, et aucune fissure n'est observée sur le film fin. L'on en conclut qu'une dose d'insolation de 3 à 4 fois supérieure à la dose préconisée par le fabricant permet de rigidifier le film souple et de le rendre plus adhésif. Ces deux propriétés font que le transfert sans fissure d'un film monocristallin de 200 nm de Silicium devient possible.

### Exemple 2 :

Des motifs rectangulaires de 2 x 42 mm² de silicium sont définis, grâce à un procédé de photolithographie associé à une gravure, sur une structure de type SOI comprenant, depuis sa première face, une couche de 200 nm de Si, puis une couche de 400 nm d'oxyde enterré. L'empilement 1 ainsi obtenu subit les mêmes étapes que l'empilement 1 de l'exemple 1. Après obtention de films fins, correspondants aux motifs susmentionnés, sur la poignée temporaire, utilisée en tant que substrat 12, on lamine un film souple adhésif Furukawa SP-537T-230 sur les films minces, puis on insole celui-ci avec une dose de 4 J/cm². On peut ensuite démonter la poignée temporaire et on obtient des motifs de silicium transférés sur un film flexible monté sur un cadre métallique. On peut alors découper le film flexible pour étudier ou utiliser individuellement chaque motif de silicium.

L'invention n'est pas limitée aux modes de réalisations précédemment décrits et s'étend à tous les modes de réalisation couverts par les revendications.

Notamment, le film mince 11 peut être composé à base de, ou être constitué de, un matériau magnétique ou piézo-électrique. Lorsque le film mince est composé à base de, ou être constitué de, un matériau semi-conducteur, ce matériau n'est pas nécessairement du silicium, mais peut également être à base de germanium, de nitrure d'aluminium, de nitrure de gallium ou de phosphure d'indium.

D'autres films adhésifs souples du commerce, tels que ceux connus sous les appellations commerciales Lintec D510T et Lintec D650, peuvent être utilisés en tant que support souple.

D'autres polymères réticulables aux UV que le polymère acrylate sont également envisageables, tels que les polyméthacrylates et les polyvinyl siloxanes.

Par ailleurs, si l'invention trouve des applications particulièrement avantageuses dans le domaine de l'électronique sur support souple, elle n'est pas limitée à ce type d'applications. Elle peut par exemple être appliquée à l'ingénierie des contraintes, notamment sur un film mince métallique comme le sodium.

## Revendications

1. Procédé de transfert (100) d'un film mince (11) depuis un substrat (12) sur un support souple (2), le procédé comprenant les étapes suivantes:
- Fournir (110) un empilement (1) comprenant au moins un film mince (11) s'étendant sur une première face du substrat (12), chaque film mince (11) adhérant à la première face du substrat (12) avec une énergie d'adhérence donnée,
- Fournir (120) un support souple (2) comprenant au moins une couche (21) à base d'un polymère réticulable par insolation aux ultra-violets, le polymère réticulable étant tel qu'au moins sa rigidité et son énergie d'adhérence évoluent en fonction de son taux de réticulation, l'énergie d'adhérence du polymère réticulable évoluant de façon non monotone en fonction du taux de réticulation du polymère, en décroissant depuis une énergie d'adhérence initiale, correspondant à un taux de réticulation initial du polymère, jusqu'à atteindre une énergie d'adhérence minimale pour un taux de réticulation nominal, puis en croissant pour un taux de réticulation supérieur au taux de réticulation nominal, le polymère comprenant, ou consistant en, un polymère acrylate,
- Reporter (130) la couche de polymère (21) du support souple (2) directement sur ledit au moins un film mince (11) de l'empilement (1), le polymère présentant un taux de réticulation inférieur au taux de réticulation nominal, puis
- Appliquer (140), sur la couche de polymère (21) du support souple (2), une insolation aux ultra-violets paramétrée de sorte que le taux de réticulation du polymère soit supérieur au taux de réticulation nominal pour rigidifier la couche de polymère (21) et avoir une énergie d'adhérence entre le film mince (11) et le support souple (2) supérieure à l'énergie d'adhérence entre le film mince (11) et le substrat (12), puis
- Retirer (150) le substrat,
de sorte que le film mince (11) se trouve transféré sur le support souple (2).

2. Procédé (100) selon la revendication précédente, dans lequel, la rigidité du polymère réticulable croissant de façon monotone à mesure que le taux de réticulation du polymère croît, l'application (140) de l'insolation aux ultra-violets est paramétrée de sorte que le support souple (2) présente, après l'application (140) de l'insolation aux ultra-violets et avant le retrait (150) du substrat (12), un module d'Young au moins 1,5 fois, de préférence au moins 2 fois, plus élevé que son module d'Young avant l'application (140) de l'insolation aux ultra-violets.

3. Procédé (100) selon la revendication précédente, dans lequel l'application (140) de l'insolation aux ultra-violets est paramétrée de sorte que le support souple (2) présente, après l'application (140) de l'insolation aux ultra-violets et avant le retrait (150) du substrat (12), un module d'Young inférieur à 100 fois, de préférence inférieur à 40 fois, son module d'Young avant l'application (140) de l'insolation aux ultra-violets.

4. Procédé (100) selon l'une quelconque des revendications précédentes, dans lequel, le taux de réticulation nominal étant connu pour être atteint en appliquant une dose d'insolation nominale donnée sur la couche en polymère telle que reportée (130), l'application (140) de l'insolation aux ultra-violets est paramétrée de sorte d'appliquer, sur la couche en polymère telle que reportée (130), une dose d'insolation au moins 3 fois plus élevée que ladite dose d'insolation nominale.

5. Procédé (100) selon l'une quelconque des revendications précédentes, dans lequel, le taux de réticulation nominal étant connu pour être atteint en appliquant une dose d'insolation nominale donnée sur la couche en polymère telle que reportée (130), l'application (140) de l'insolation aux ultra-violets est paramétrée de sorte d'appliquer, sur la couche en polymère telle que reportée (130), une dose d'insolation inférieure à 10 fois, éventuellement inférieure à 4 fois, ladite dose d'insolation nominale.

6. Procédé (100) selon l'une quelconque des revendications précédentes, dans lequel la fourniture (120) du support souple (2) est paramétrée de sorte que le polymère réticulable présente une énergie d'adhérence avec le film mince (11) supérieure à l'énergie d'adhérence entre le film mince (11) et le substrat (12), le report (130) de la couche de polymère (21) sur le film mince (11) comprenant alors un collage de l'un sur l'autre.

7. Procédé (100) selon l'une quelconque des revendications précédentes, dans lequel le support souple (2) présente, avant l'application (140) de l'insolation aux ultra-violets, un module d'Young strictement inférieur à 10 MPa, de préférence inférieur à 2 MPa.

8. Procédé (100) selon l'une quelconque des revendications précédentes, dans lequel le film mince (11) est composé à base de, ou est constitué de, un matériau magnétique, métallique, piézo-électrique ou semi-conducteur.

9. Procédé (100) selon l'une quelconque des revendications précédentes, dans lequel le film mince (11) comprend un matériau cristallin.

10. Procédé (100) selon l'une quelconque des revendications précédentes, dans lequel le report (130) de la couche de polymère (21) sur le film mince (11) est réalisé par laminage ou par épandage d'au moins une partie du support souple (2), et plus particulièrement d'au moins la couche de polymère (21), sur le film mince (11).

11. Procédé (100) selon l'une quelconque des revendications précédentes, dans lequel le substrat (12) présente un module d'Young au moins 10 fois supérieur au module d'Young du support souple (2) après l'application (140) de l'insolation aux ultra-violets.

12. Procédé (100) selon l'une quelconque des revendications précédentes, dans lequel le support souple (2) comprend en outre un film structurant (22) sur lequel la couche en polymère est déposée, le film structurant (22) étant en un matériau transparent aux ultra-violets, par exemple en polyéthylène.

13. Procédé (100) selon l'une quelconque des revendications précédentes, dans lequel l'empilement (1) fourni (110) comprend une pluralité de films minces (11) disjoints entre eux et répartis sur la première face du substrat (12), de sorte que la pluralité de films minces (11) se trouve transférée sur le support souple (2).

14. Procédé de fabrication d'un dispositif microélectronique comprenant la mise en œuvre d'un procédé de transfert (100) d'un film mince (11) depuis un substrat (12) sur un support souple (2) selon l'une quelconque des revendications précédentes.
